# EUROPEAN PATENT SPECIFICATION

(11) **EP 2 825 452 B1**
(45) Date of publication and mention of the grant of the patent: **31.08.2016**
(21) Application number: 13713293.2
(22) Date of filing: 14.03.2013
(51) Int. Cl.: B64D 11/00, B64D 11/06

(54) **In-flight entertainment arrangement**
Fluggastunterhaltungsanordnung
Ensemble de divertissement en vol

(30) Priority: 14.03.2012 US 201261610514 P
(43) Date of publication of application: 21.01.2015
(73) Proprietor: B/E Aerospace Inc., Wellington, FL 33414 (US)
(72) Inventor: WALLACE, Andrew, Gordon, Nr. Newant Gloucestershire GL18 1HJ (GB); RUTTER, Paul, Benedict, Warwick Warwickshire CV34 4UJ (GB); MITCHELL, Andrew, David, Leamington Spa Warwickshire CV326PX (GB); JOHNSON, Glenn, Allen, Rural Hall, NC 27045 (US)
(74) Representative: Appleyard Lees IP LLP
(86) International application number: PCT/US2013/031158
(87) International publication number: WO 2013/138551

(56) References cited:
- DE-A1- 19 800 538
- US-A- 5 177 616
- US-A- 5 374 104
- US-A1- 2011 278 885

## Description

### Technical Field and Background of the Invention

The present invention relates to the field of passenger aircraft, and more particularly, to in-flight entertainment monitors located within a passenger cabin. This invention relates to a deployable in-flight entertainment monitor mounted on a support mechanism that permits the monitor to be either manually or automatically deployed, from a portrait to a landscape orientation, as desired.

Aircraft passenger cabins may include in-flight entertainment monitors. Such monitors typically provide passengers with both information concerning the flight, as well as entertainment. Flight information may include safety information, flight progress information, destination information, weather information, and the like. Entertainment may include television programing, movies, music, commercial advertisements, video games, internet access, and the like.

In-flight entertainment monitors are typically fixed to a variety of objects within the passenger cabin for viewing purposes within the cabin. For instance, in-flight entertainment monitors may be fixed to seat backs, bulkhead walls or partitions. When attached to seat backs, in-flight entertainment monitors are typically fixed in their landscape orientation and face rearward for the benefit and use of an aft-seated passenger. For privacy purposes, premium class seating may include partitions separating seats, beds and/or seating areas. When positioned on such partitions, in-flight entertainment monitors are typically fixed in their landscape orientation and attached to a rearward portion of a partition facing the passenger. Similarly, in-flight entertainment monitors are typically positioned on bulkhead walls located at various points within the passenger cabin.

An In-flight entertainment arrangement is known from US5374104, which shows the features of the preamble of claim1.

In the field of passenger aircraft, it is desirable for in-flight entertainment monitors to be as large as possible and practical for the purposes of visual entertainment purposes and communicating information to passengers. A larger size may also provide a larger image for those passengers with impaired vision. Having a larger display size is especially desirable for premium class seating. However, within passenger aircraft, space is limited. Also, for passenger safety during boarding and exiting the aircraft and during periods of turbulence, it is desirable that fixtures, such as in-flight entertainment monitors, not protrude from the objects and fixtures to which they are attached. Such protrusions may hinder ingress and egress from a seating or other passenger area. As such, the size of the display may be limited by the object to which it is fixed so as not to protrude from the object and so as not to consume valuable space.

Further, depending on the particular entertainment or information displayed, it may be desirable to have the in-flight entertainment monitor fixed in a portrait orientation. Similarly, it may be desirable to have the in-flight entertainment monitor fixed in the landscape orientation. It may also be desirable to provide the option of displaying in either portrait or landscape orientation.

Accordingly, there is a need in the art for a large display in-flight entertainment monitor that is deployable in both a portrait and a landscape orientation depending on various in-flight applications. Further, there is a need in the art for an in-flight entertainment monitor that does not protrude or otherwise impede passenger safety. There is also a need in the art for an in-flight entertainment monitor that accomplishes these tasks that may still be attached to various different objects and fixtures such as seat backs, bulkhead walls and seat partitions within the aircraft.

### Summary of the Invention

It is therefore an object of the present invention to provide a deployable in-flight entertainment monitor that is mounted on a support mechanism that permits the monitor to be either manually, remotely or automatically deployed from a stowed position to a deployed position as desired, as defined by the features of claim 1.

It is a further object of the invention to provide a deployable in-flight entertainment monitor that can be mounted without overhangs or protrusions onto an aircraft fixture such as a partition, seatback or bulkhead wall that is smaller in width than the length of the display in its deployed, viewing orientation.

It is a further object of the invention to provide a deployable in-flight entertainment monitor in which, in its normally stowed position, the monitor is positioned vertically in a portrait aspect ratio to display to the passenger in-flight information, but can be deployed into a full in-flight entertainment mode with a landscape, wide screen orientation.

These and other objects and advantages of the invention are achieved by providing a deployable in-flight entertainment monitor including an aircraft fixture having a rearward facing surface and a monitor attached to the rearward facing surface of the aircraft fixture. The monitor operates from a stowed position, where the monitor is in a portrait orientation for the display of information, to a deployed position, where the monitor is in a landscape orientation for the display of entertainment. Control guide ways are attached to the rear of the monitor. The control guide ways have circular pathways that support the attachment of the monitor to the aircraft fixture and that facilitate the operation of the monitor from the stowed position to the deployed position.

According to another embodiment of the invention, when the monitor is in the stowed position, a stowed vertical height of the monitor may be longer than a horizontal width of the aircraft fixture and a stowed horizontal width of the monitor may be shorter than the horizontal width of the aircraft fixture. Further, in the deployed position, a deployed horizontal width of the monitor may be longer than the horizontal width of the aircraft fixture.

According to another embodiment of the invention, in the stowed position, the monitor may not overhang from the aircraft fixture.

According to another embodiment of the invention, in the deployed position, the monitor may overhang from the aircraft fixture.

According to another embodiment of the invention, the aircraft fixture may be a partition, a seat back or a bulkhead wall.

According to another embodiment of the invention, the monitor may operate from the stowed position to the deployed position and from the deployed position to the stowed position by a manual operation performed by a passenger.

According to another embodiment of the invention, the monitor may operate from the stowed position to the deployed position and from the deployed position to the stowed position by an automatic operation.

According to another embodiment of the invention, the monitor may operate from the stowed position to the deployed position and from the deployed position to the stowed position by a remote automatic operation of an aircraft crew member.

According to another embodiment of the invention, there may be a total of two control guide ways.

According to another embodiment of the invention, there may be a total of three control guide ways.

### Brief Description of the Drawings

The present invention is best understood when the following detailed description of the invention is read with reference to the accompanying drawings, in which:
FIG. 1 is a perspective view of a first class-type aircraft passenger seating area, including an in-flight entertainment monitor attached to a partition according to an embodiment of the invention;
FIG. 2 is an elevation view of the in-flight entertainment monitor in its deployed, horizontal, landscape orientation;
FIGS. 3 and 4 are elevation views of the in-flight entertainment monitor in a transition position from the landscape wide screen deployed position to a portrait vertical stowed position; and
FIG. 5 is an elevation view of the in-flight entertainment monitor in its portrait vertical stowed position.

### Description of the Preferred Embodiment and Best Mode

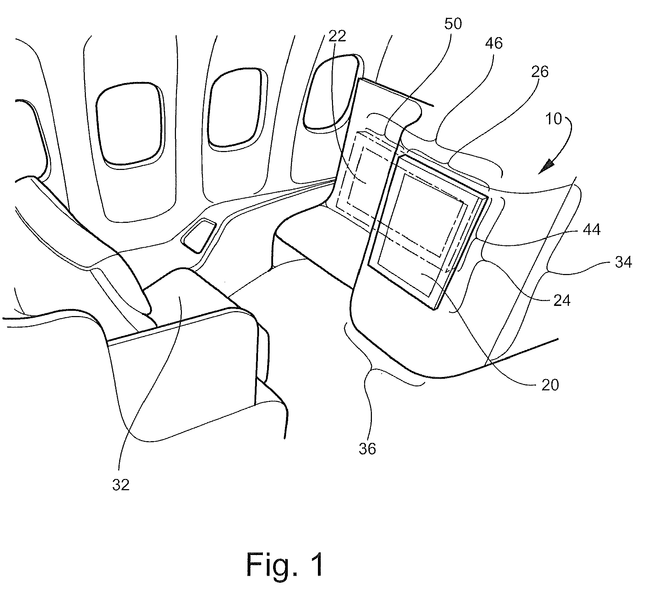

Referring now specifically to the drawings, an in-flight entertainment monitor is shown generally at reference numeral 10. Referring to FIG. 1, the in-flight entertainment monitor 10 is configured to move and operate from a vertical portrait stowed position 20 to a horizontal landscape deployed position 22. The in-flight entertainment monitor 10 is attached to a rearward facing portion of an aircraft fixture that may be a seat partition 30. An aircraft passenger seated in the aircraft passenger seat 32 may observe information displayed on the in-flight entertainment monitor 10 when the monitor is in the stowed position 20. An aircraft passenger seated in the aircraft passenger seat 32 may observe entertainment displayed on the in-flight entertainment monitor 10 when the monitor is in the deployed position 22.

The seat partition 30 is defined by a height 34 and a width 36. In the stowed position 20, the monitor 10 is defined by a stowed height 24 and a stowed width 26. The stowed width 26 of the monitor 10 in the stowed position 20 is less than the width 36 of the partition 30. The stowed width 26 of the monitor 10 does not overhang the partition 30.

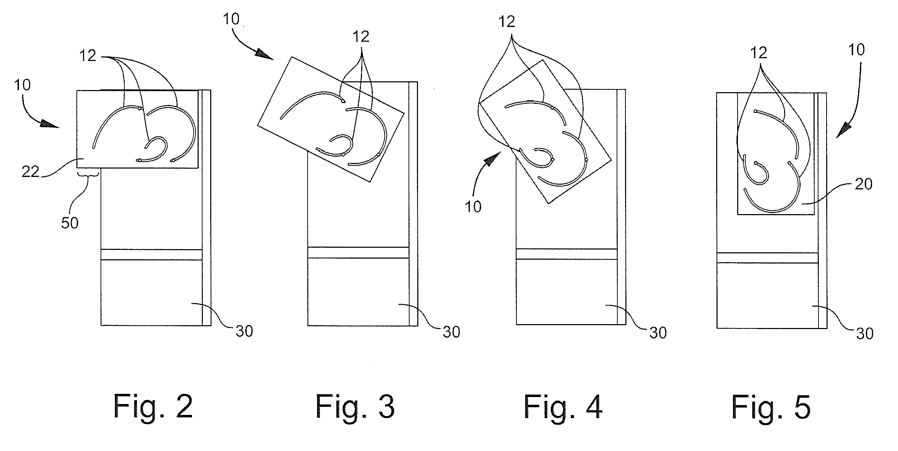

Once the monitor 10 has operated from the stowed position 20, as shown in FIG. 5, to the deployed position 22, as shown in FIG. 2, the monitor 10 is defined by a deployed height 44 and a deployed width 46. The deployed height 44 of the monitor 10 is equal in length to the stowed width 26 of the monitor 10. The deployed width 46 of the monitor 10 is equal to the stowed height 24 of the monitor 10. The deployed width 46 of the monitor 10 is greater than the width 36 of the partition 30. The deployed width 46 of the monitor 10 overhangs 50 the partition 30.

Referring to FIGS. 2-5, the monitor 10 includes a support mechanism in the form of control guide ways 12. The guide ways 12 may be driven by a driving gear pinion (not shown) that allows the monitor 10 to be either automatically or manually deployed between the stowed position 20 and the deployed position 22. This deployable capability enables the monitor 10 to be mounted in the stowed position 20 without overhangs 50 or protrusions onto a partition 30 that is smaller in width 36 than the width 46 of the monitor 10 in its deployed position 22. In its normally stowed position 20 shown in FIG. 5, the monitor 10 is positioned vertically in a portrait aspect ratio. In this stowed position 20 it can be used to display to the passenger seated in aircraft seat 32 a range of in-flight information. However, when full in-flight entertainment functionality is required, the passenger seated in seat 32, as shown in FIG. 1, will deploy the monitor 10 from its stowed position 20, as shown in FIG. 5, into a landscape/wide-screen deployed position 22, as shown in FIG. 2. This deployment can be achieved in a number of ways.

In one preferred embodiment, the guide ways 12 may include a circular arc toothed rack mounted on the back of the monitor 10 which meshes with a motorized pinion gear to drive the monitor 10 between its stowed 20 and deployed 22 positions. The curved guide ways 12 support the monitor 10 and guide its travel during deployment and retraction as shown in FIGS. 2-5. The drive is reversible and can be used to both deploy and retract the monitor 10.

Referring to FIGS. 2-5, the movement of the monitor 10 from the deployed landscape orientation to the stowed portrait orientation is shown in consecutive steps. Comparing FIGS. 2 and 5, the monitor does not simply pivot about a single point, but translates while rotating. This is evidenced by the fact that the 'top' of the monitor 10 is aligned with the top of the partition 30 in FIG. 2 when the monitor is in landscape, and the 'side' of the monitor is aligned with the top of the partition 30 in FIG. 5 when the monitor is in portrait. Thus, the monitor 10 both rotates and translates as it moves between the stowed and deployed positions. The degree of vertical and horizontal translation is controlled by the shapes of the guide ways 12, which are slots. The shape, position and length of the guide slots can be tailored to customize the translation movement. The number of guide ways 12 and monitor supports may also be customized depending on the size, weight and shape of the monitor.

In an alternative embodiment, the rack and pinion arrangement may be replaced with a powered actuator acting on a pin and bearing running in a third guide way. In yet another preferred embodiment, a spring and damper arrangement may be used to achieve the monitor 10 deployment once a latch is released. The monitor 10 is then returned to its stowed position 20 and latched manually.

A deployable in-flight entertainment monitor 10 according to the invention has been described with reference to specific embodiments and examples. Various details of the invention may be changed without departing from the scope of the invention. Furthermore, the foregoing description of the preferred embodiments of the invention, and best mode for practicing the invention are provided for the purpose of illustration only and not for the purpose of limitation, the invention being defined by the claims.

## Claims

1. A deployable in-flight entertainment arrangement comprising:
a fixture (30) having a supporting surface;
a monitor (10) attached to the supporting surface of the fixture (30) and moveable relative thereto between a stowed position (20) wherein the monitor (10) is in a portrait orientation to a deployed position (22) wherein the monitor (10) is in a landscape orientation;
**characterized in that** the monitor (10) is configured to be viewed in both the deployed (22) and stowed (20) positions; and
a plurality of control guide ways (12) attached to the rear of the monitor (10) supporting the attachment of the monitor (10) to the fixture (30) and controlling movement of the monitor (10) from the stowed position (20) to the deployed position (22).

2. The deployable in-flight entertainment arrangement of claim 1, wherein in the stowed position (20), a stowed vertical height (24) of the monitor (10) is longer than a horizontal width (36) of the fixture (30) and a stowed horizontal width (26) of the monitor (10) is shorter than the horizontal width (36) of the fixture (30), and in the deployed position (22) a deployed horizontal width (46) of the monitor (10) is longer than the horizontal width (36) of the fixture (30).

3. The deployable in-flight entertainment arrangement of claim 1, wherein in the stowed position (20), the monitor (10) does not overhang the fixture (30).

4. The deployable in-flight entertainment arrangement of claim 3, wherein in the deployed position (20), the monitor (10) overhangs from aircraft fixture (30).

5. The deployable in-flight entertainment arrangement of claim 1, wherein the monitor (10) rotates, translates horizontally, and translates vertically as the monitor (10) moves between the stowed (20) and deployed (22) positions.

6. The deployable in-flight entertainment arrangement of claim 1, wherein the aircraft fixture (30) is one of a seat back, bulkhead wall and partition.

7. The deployable in-flight entertainment arrangement of claim 1, further comprising three guide ways (12) for controlling rotational and translation movement of the monitor (10) with respect to the fixture (30), each of the guide ways (12) defining an arcuate path.

8. The deployable in-flight entertainment arrangement of any preceding claim wherein the fixture (30) is an aircraft fixture (30) having a rearward facing surface defined by a height and a width, the monitor (10) is attached to the rearward facing surface of the aircraft fixture (30) such that the monitor (10) is arranged to move by way of combined rotational and translation motion between the stowed position (20) in which the monitor (10) is within the width (36) of the aircraft fixture (30), and the deployed position (22) in which the monitor (10) overhangs the width (36) of the aircraft fixture (30) and each of the control guide ways (12) define a circular pathway guiding the combined rotational and translational motion of the monitor (10).

9. The deployable in-flight entertainment arrangement of claim 8, wherein the monitor (10) moves from the stowed position (20) to the deployed position (22) and from the deployed position (22) to the stowed position (20) manually.

10. The deployable in-flight entertainment arrangement of claim 8, wherein the monitor (10) moves from the stowed position (20) to the deployed position (22) and from the deployed position (22) to the stowed position (20) automatically.

11. The deployable in-flight entertainment arrangement of claim 8, wherein the number of guide ways (12) is three.

12. The deployable in-flight entertainment arrangement of claim 8, wherein the number of guide ways (12) is two.

## Patentansprüche

1. Aufklappbare Fluggastunterhaltungsanordnung, umfassend:
eine Halterung (30), die eine Stützfläche aufweist;
einen Monitor (10), der an der Stützfläche der Halterung (30) befestigt ist und in Bezug darauf zwischen einer verstauten Position (20), in welcher der Monitor (10) in einer Hochformatausrichtung ist, zu einer aufgeklappten Position (22), in welcher der Monitor (10) in einer Querformatausrichtung ist, beweglich ist;
**dadurch gekennzeichnet, dass** der Monitor (10) sowohl in der aufgeklappten (22) als auch verstauten Position (20) sichtbar ist; und
eine Vielzahl von Steuerführungen (12), die an der Hinterseite des Monitors (10) befestigt sind und die Halterung des Monitors (10) an der Halterung (30) abstützen und die Bewegung des Monitors (10) von der verstauten Position (20) zur aufgeklappten Position (22) steuern.

2. Aufklappbare Fluggastunterhaltungsanordnung nach Anspruch 1, wobei in der verstauten Position (20) eine verstaute vertikale Höhe (24) des Monitors (10) länger als eine horizontale Breite (36) der Halterung (30) ist und eine verstaute horizontale Breite (26) des Monitors (10) kürzer als die horizontale Breite (36) der Halterung (30) ist, und in der aufgeklappten Position (22) eine horizontale aufgeklappte Breite (46) des Monitors (10) länger als die horizontale Breite (36) der Halterung (30) ist.

3. Aufklappbare Fluggastunterhaltungsanordnung nach Anspruch 1, wobei in der verstauten Position (20) der Monitor (10) nicht über die Halterung (30) hängt.

4. Aufklappbare Fluggastunterhaltungsanordnung nach Anspruch 3, wobei in der aufgeklappten Position (20) der Monitor (10) über die Flugzeughalterung (30) hängt.

5. Aufklappbare Fluggastunterhaltungsanordnung nach Anspruch 1, wobei der Monitor (10) dreht, horizontal übersetzt und vertikal übersetzt, während sich der Monitor (10) zwischen der verstauten (20) und der aufgeklappten Position (22) bewegt.

6. Aufklappbare Fluggastunterhaltungsanordnung nach Anspruch 1, wobei die Flugzeughalterung (30) eine von Sitzrückenlehne, Schottwand und Trennwand ist.

7. Aufklappbare Fluggastunterhaltungsanordnung nach Anspruch 1, ferner umfassend drei Führungen (12) zum Steuern der Dreh- und Übersetzungsbewegung des Monitors (10) in Bezug auf die Halterung (30), wobei jede Führung (12) eine gekrümmte Bahn definiert.

8. Aufklappbare Fluggastunterhaltungsanordnung nach einem der vorhergehenden Ansprüche, wobei die Halterung (30) eine Flugzeughalterung (30) ist, die eine nach hinten weisende Oberfläche aufweist, die von einer Höhe und einer Breite definiert wird, wobei der Monitor (10) an der nach hinten weisenden Oberfläche der Flugzeughalterung (30) befestigt ist, sodass der Monitor (10) zum Bewegen mittels einer kombinierten Dreh- und Übersetzungsbewegung zwischen der verstauten Position (20), in welcher der Monitor (10) innerhalb der Breite (36) der Flugzeughalterung (30) ist, und der aufgeklappten Position (22), in welcher der Monitor (10) die Breite (36) der Flugzeughalterung (30) überhängt, angeordnet ist, wobei jede der Steuerungsführungen (12) eine runde Bahnführung der Dreh- und Übersetzungsbewegung des Monitors (10) definiert.

9. Aufklappbare Fluggastunterhaltungsanordnung nach Anspruch 8, wobei der Monitor (10) manuell aus der verstauten Position (20) zur aufgeklappten Position (22) und von der aufgeklappten Position (22) zur verstauten Position (20) bewegt wird.

10. Aufklappbare Fluggastunterhaltungsanordnung nach Anspruch 8, wobei der Monitor (10) automatisch aus der verstauten Position (20) zur aufgeklappten Position (22) und von der aufgeklappten Position (22) zur verstauten Position (20) bewegt wird.

11. Aufklappbare Fluggastunterhaltungsanordnung nach Anspruch 8, wobei die Anzahl an Führungen (12) drei beträgt.

12. Aufklappbare Fluggastunterhaltungsanordnung nach Anspruch 8, wobei die Anzahl an Führungen (12) zwei beträgt.

## Revendications

1. Ensemble déployable de divertissement en vol, comprenant:
une monture (30) présentant une surface de support;
un écran (10) attaché à la surface de support de la monture (30) et mobile par rapport à celle-ci entre une position arrimée (20), dans laquelle l'écran (10) est placé dans une orientation portrait, et une position déployée (22), dans laquelle l'écran (10) est placé dans une orientation paysage;
**caractérisé en ce que** l'écran (10) est configuré de manière à être vu à la fois dans la position déployée (22) et dans la position arrimée (20); et
une pluralité de voies de guidage de commande (12) attachées à l'arrière de l'écran (10) qui supportent la fixation de l'écran (10) à la monture (30) et qui commandent le déplacement de l'écran (10) depuis la position arrimée (20) jusqu'à la position déployée (22).

2. Ensemble déployable de divertissement en vol selon la revendication 1, dans lequel, dans la position arrimée (20), une hauteur verticale arrimée (24) de l'écran (10) est plus longue qu'une largeur horizontale (36) de la monture (30), et une largeur horizontale arrimée (26) de l'écran (10) est plus courte que la largeur horizontale (36) de la monture (30) et, dans la position déployée (22), une largeur horizontale déployée (46) de l'écran (10) est plus longue que la largeur horizontale (36) de la monture (30).

3. Ensemble déployable de divertissement en vol selon la revendication 1, dans lequel, dans la position arrimée (20), l'écran (10) ne surplombe pas la monture (30).

4. Ensemble déployable de divertissement en vol selon la revendication 3, dans lequel dans la position déployée (20), l'écran (10) surplombe la monture d'avion (30).

5. Ensemble déployable de divertissement en vol selon la revendication 1, dans lequel l'écran (10) tourne, se déplace horizontalement et se déplace verticalement lorsque l'écran (10) se déplace entre les positions arrimée (20) et déployée (22).

6. Ensemble déployable de divertissement en vol selon la revendication 1, dans lequel la monture d'avion (30) est soit un dossier de siège, soit une cloison d'étanchéité, soit une paroi de séparation.

7. Ensemble déployable de divertissement en vol selon la revendication 1, comprenant en outre trois voies de guidage (12) pour commander le déplacement rotatif et translatif de l'écran (10) par rapport à la monture (30), chacune des voies de guidage (12) définissant un chemin courbe.

8. Ensemble déployable de divertissement en vol selon l'une quelconque des revendications précédentes, dans lequel la monture (30) est une monture d'avion (30) présentant une surface orientée vers l'arrière définie par une hauteur et une largeur, l'écran (10) est attaché à la surface orientée vers l'arrière de la monture d'avion (30) de telle sorte que l'écran (10) soit agencé de manière à se déplacer par l'entremise de son mouvement de rotation et de translation combiné entre la position arrimée (20), dans laquelle l'écran (10) est situé à l'intérieur de la largeur (36) de la monture d'avion (30), et la position déployée (22), dans laquelle l'écran (10) surplombe la largeur (36) de la monture d'avion (30), et chacune des voies de guidage de commande (12) définit un chemin circulaire qui guide le mouvement de rotation et de translation combiné de l'écran (10).

9. Ensemble déployable de divertissement en vol selon la revendication 8, dans lequel l'écran (10) se déplace depuis la position arrimée (20) jusqu'à la position déployée (22) et depuis la position déployée (22) jusqu'à la position arrimée (20) manuellement.

10. Ensemble déployable de divertissement en vol selon la revendication 8, dans lequel l'écran (10) se déplace depuis la position arrimée (20) jusqu'à la position déployée (22) et depuis la position déployée (22) jusqu'à la position arrimée (20) automatiquement.

11. Ensemble déployable de divertissement en vol selon la revendication 8, dans lequel le nombre de voies de guidage (12) est trois.

12. Ensemble déployable de divertissement en vol selon la revendication 8, dans lequel le nombre de voies de guidage (12) est deux.
